(19) Europäisches Patentamt
European Patent Office
Office européen des brevets

(11) **EP 2 190 121 B1**

(12) **EUROPÄISCHE PATENTSCHRIFT**

(45) Veröffentlichungstag und Bekanntmachung des Hinweises auf die Patenterteilung:
**18.05.2011 Patentblatt 2011/20**

(51) Int Cl.:
***H03M 3/02*** *(2006.01)*

(21) Anmeldenummer: **08020314.4**

(22) Anmeldetag: **21.11.2008**

(54) **Mehrkanaliger AD-Wandler**

Multi-channel A/D converter

Convertisseur analogique-numérique multicanal

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(43) Veröffentlichungstag der Anmeldung:
**26.05.2010 Patentblatt 2010/21**

(73) Patentinhaber: **SICK AG**
**79183 Waldkirch/Breisgau (DE)**

(72) Erfinder:
• **Hug, Gottfried**
**79183 Waldkirch-Siensbach (DE)**
• **Bohli, Alexander**
**79189 Bad Krozingen (DE)**
• **Heindl, Jakob**
**79117 Freiburg (DE)**

(74) Vertreter: **Manitz, Finsterwald & Partner GbR**
**Postfach 31 02 20**
**80102 München (DE)**

(56) Entgegenhaltungen:
**US-A1- 2008 024 348    US-B1- 6 246 258**

**Beschreibung**

Die Erfindung betrifft einen mehrkanaligen AD-Wandler (Analog/ DigitalWandler) zur Wandlung mehrerer analoger Eingangssignale in ein jeweiliges digitales Ausgangssignal.

Sollen mit einem FPGA (Field Programmable Gate Array) analoge Größen wie insbesondere Spannungen und/oder Ströme ausgewertet werden, so müssen diese zunächst einer Analog/Digital-Wandlung unterzogen werden. Die einfachste Möglichkeit, eine solche Wandlung durchzuführen, bieten fertige ICs (Intgrierte Schaltungen), wie sie auf dem Markt verfügbar sind. Solche ICs sind jedoch aufgrund ihres Platzbedarfes auf der jeweiligen Leiterkarte, der Leistungsaufnahme, des anfallenden Kommunikationsaufwandes zum FPGA und nicht zuletzt aufgrund ihrer hohen Kosten für viele einfache Wandleraufgaben ungeeignet.

Zur Analog/ Digital-Wandlung sind auch bereits das Single- oder Dual-Slope-Verfahren oder die Sukzessive Approximation (vgl. z.B. US 6,246,258 B1) bekannt. Diese Verfahren bringen gegenüber den herkömmlichen ICs zwar eine Verbesserung hinsichtlich der Kosten, der Leistungsaufnahme und des Kommunikationsaufwandes mit sich. Aufgrund ihrer erhöhten Störanfälligkeit sind sie jedoch beispielsweise für Überwachungsaufgaben in sicherheitsrelevanten Systemen nicht sinnvoll einsetzbar. Zudem bedingt dieses Verfahren einen fortlaufenden Entscheidungsprozess, bei dem analoge Störgrößen am Beginn des Prozesses zu Fehlentscheidungen und damit zu beträchtlichen Fehlern führen.

Eine weitere Möglichkeit zur Durchführung einer Digital/Analog-Wandlung ist mit dem bekannten Sigma-Delta ($\Sigma\Delta$)-Verfahren gegeben. Dieses Verfahren wurde bereits mit unterschiedlichem Aufwand mit analogen und digitalen Elementen bzw. voll integriert umgesetzt. Dabei wird bisher jeweils ein $\Sigma\Delta$-Modulator eingesetzt, in dessen Rückkoppelschleife ein Integrator in Form eines Operationsverstärkers vorgesehen ist.

Aus der US 6,246,258 B1 ist überdies ein so genannter Flash-AD-Wandler bekannt. Für die Realisierung eines solchen Wandlers werden jedoch für n Bit $2^n$ - 1 Komparatoren benötigt. Für eine 10 Bit-Auflösung sind somit 1023 Komparatoren erforderlich, was einer realistischen Umsetzung entgegensteht.

Zu den Nachteilen der bekannten AD-Wandler bzw. -Verfahren zählen somit insbesondere eine relativ hohe Störanfälligkeit, eine zu geringe Auflösung, eine zu geringe Genauigkeit, zu hohe Toleranzen, eine zu hohe Temperaturempfindlichkeit, eine zu hohe Leistungsaufnahme, ein zu hoher Ressourcenverbrauch im FPGA, ein zu hoher Platzbedarf auf der elektronischen Leiterplatte (PCB, Printed Circuit Board), eine relativ große Bauteilmenge sowie die relativ hohen Kosten.

Der Erfindung liegt die Aufgabe zugrunde, einen mehrkanaligen AD-Wandler zu schaffen, der möglichst ressourcenschonend mit einem FGPA umsetzbar ist.

Diese Aufgabe wird erfindungsgemäß durch einen mehrkanaligen AD-Wandler mit den Merkmalen des Anspruchs 1 gelöst.

Der erfindungsgemäße mehrkanalige AD-Wandler zur Wandlung mehrerer analoger Eingangssignale in ein jeweiliges digitales Ausgangssignal zeichnet sich dadurch aus, dass er einen $\Sigma\Delta$-Modulator mit mehreren jeweils einem Eingangssignal zugeordneten Eingangskomparatoren, einer diesen über einen Multiplexer nachgeordneten Samplingeinheit und einer einen DA-Wandler sowie einen Filter aufweisenden Rückkoppelschleife umfasst, über die das Ausgangssignal der Samplingeinheit zu den Eingangskomparatoren zurückgeführt ist. Dabei sind die Eingangskomparatoren, der Multiplexer, die Samplingeinheit und der DA-Wandler in einem FGPA realisiert, während der Filter als Analogfilter ausgeführt und außerhalb des FPGA vorgesehen ist.

Mit diesem auf dem $\Sigma\Delta$-Prinzip basierenden mehrkanaligen AD-Wandler können mit sehr kleinem Bauteilaufwand mehrere Eingangssignale gemessen und gewandelt werden, wobei zur Realisierung lediglich ein geringer Teil an FPGA-Logik und ein Analogfilter benötigt werden. Aufgrund des einfachen Aufbaus ergibt sich eine kostengünstige, ressourcen-, platz- und energiesparende Form eines mehrkanaligen AD-Wandlers. Dabei werden bei guter Wandlungsqualität die Fähigkeiten des FPGAs in analogem und digitalem Sinn optimal ausgenutzt und der Aufwand an zusätzlichen analogen Komponenten gering gehalten. Zudem werden die Toleranz und die Temperaturempfindlichkeit minimiert sowie eine hohe Messqualität (Linearität und Genauigkeit), hohe Störsicherheit insbesondere gegenüber Fremdstörungen und eine hohe Auflösung (geringes Rauschen) erzielt.

Der AD-Wandler kann zur Auswertung des Ausgangssignals der Samplingeinheit eine Auswerteeinheit umfassen. Dabei ist vorzugsweise auch diese Auswerteeinheit in dem FPGA realisiert.

Die Auswerteeinheit ist bevorzugt zur Mittelung des Ausgangssignals der Samplingeinheit über einen vorgebbaren Zeitraum ausgeführt. Dazu kann sie beispielsweise wenigstens einen FIR-Filter (FIR = Finite Impulse Response) und/oder wenigstens einen CIC-Filter (CIC = Cascaded Integrator Comb) umfassen.

Die Auswerteeinheit kann insbesondere auch so ausgeführt sein, dass die in einem jeweiligen vorgebbaren Zeitfenster auftretende Abtastwerte "1" gezählt werden, wobei der sich am Ende des Zeitfensters ergebende Zählerstand dem Wandlungsergebnis entspricht.

CIC-Filter bieten gegenüber FIR-Filtern einen geringeren Ressourcenverbrauch sowie eine kürzere Einschwingzeit. Am ressourcenschonendsten ist das entsprechend bevorzugte Auszählen des vom jeweiligen Komparator kommenden Signals, wobei in einen bestimmten Zeitfenster oder Messfenster jede auftretende "1" gezählt wird. Das Zählen kann synchron zum Start eines jeden Zeitfensters von einer Steuereinheit gestartet und zum Ende hart abgebrochen werden. Nach Ablauf des Zeitfensters entspricht der Zählerstand dem Wandlungsergebnis. Die Steuereinheit kann dann auf den nächsten Komparator umschalten und das nächste Zeitfenster starten, sobald der Analogfilter sicher eingeschwungen ist. Eine möglichst schnelle, Timingfehler im Design vermeidende leistungsfähige Zählerstruktur wird insbesondere mit zwei in Reihe geschalteten Zählern erzielt.

Der AD-Wandler umfasst zweckmäßigerweise einen der Auswerteeinheit nachgeordneten, die digitalen Ausgangssignale liefernden Demultiplexer. Dabei ist vorzugsweise auch dieser Demultiplexer in dem FPGA realisiert.

Wie bereits erwähnt, umfasst der AD-Wandler bevorzugt auch eine Steuereinheit. Bevorzugt ist auch diese Steuereinheit wieder in dem FPGA realisiert.

Die Steuereinheit kann insbesondere zur Steuerung des Multiplexers, zur Steuerung der Samplingeinheit, zur Steuerung der Auswerteeinheit und/öder zur Steuerung des Demultiplexers vorgesehen sein.

Bevorzugt ist die Steuereinheit so ausgeführt, dass die Ausgangssignale der Eingangskomparatoren jeweils für ein vorgebbares Zeitfenster der Samplingeinheit zugeführt werden, ein jeweiliger Start der Samplingeinheit mit einem jeweiligen Start der Auswerteeinheit synchronisiert wird und/oder der Demultiplexer zur Ausgabe der digitalen Ausgangssignale entsprechend angesteuert wird.

Der außerhalb des FPGA vorgesehene Analogfilter kann einen RC-Filter umfassen, wobei er vorzugsweise einen mehrpoligen Filter, insbesondere mehrpoligen RC-Filter umfasst. Bevorzugt umfasst der außerhalb des FPGA vorgesehene Analogfilter einen rekursiven mehrpoligen RC-Filter. Von Vorteil ist insbesondere, wenn er einen rekursiven vierpoligen RC-Filter umfasst, dessen Abgriff insbesondere nach dem dritten Pol vorgesehen ist. Zur Realisierung des Analogfilters werden also nur zwei Bauteilsorten bzw. zwei analoge Netzwerke benötigt, also insbesondere vier identische R-Glieder und vier identische C-Glieder. Dabei ist die Anordnung, wie bereits erwähnt, vorteilhafterweise so gewählt, dass sich ein rekursiver vierpoliger Filteraufbau ergibt, der insbesondere nach dem dritten Pol abgegriffen wird.

Grundsätzlich ist jedoch auch ein anderer mehrpoliger Filter denkbar, beispielsweise ein dreipoliger Filter, wenn gegebenenfalls die größere Zahl von Bauteilen und die entsprechenden Bestückungskosten in Kauf genommen werden, um die R- und C-Glieder individuell anzupassen. So wären beispielsweise für einen dreipoligen Filter insgesamt sechs unterschiedliche R- und C-Glieder einzusetzen.

Wesentlich ist, dass der Filter als analoger Filter ausgeführt und außerhalb des FPGA realisiert wird. Alle weiteren Elemente des ΣΔ-Modulators sind in dem FPGA integriert.

Mit dem erfindungsgemäßen AD-Wandler ist es möglich, mehrere Eingangsgrößen sequenziell analog-digital zu wandeln, wozu für n Eingangsgrößen n Komparatoren im FPGA und eine vorzugsweise ebenfalls in FPGA realisierte Steuerlogik vorgesehen sind. Die Steuerlogik übernimmt hierbei insbesondere die folgenden drei Aufgaben:

Sie sorgt dafür, dass die Ausgangssignale der Komparatoren für ein bestimmtes Zeitfenster der Samplingeinheit des ΣΔ-Modulators zugeführt werden. Sie synchronisiert den Start der Abtast- oder Samplingeinheit mit dem Start der Auswerteeinheit, und sie steuert die Ausgabe des Wandlungsergebnisses über den Demultiplexer.

Für die Auswertung des vom ΣΔ-Modulators erzeugten Signals wird nur eine Auswerteeinheit benötigt. Es ist also möglich, durch den Einsatz der umgesetzten Steuerlogik und n Komparatoren einen mehrkanaligen ΣΔ-Wandler zu realisieren. Die Anzahl der extern erforderlichen analogen Bauteile insbesondere des Analogfilters bleibt unverändert. Es ist auch nur eine Steuereinheit erforderlich, die vorzugsweise ebenfalls wieder im FPGA realisiert ist.

Zur Wandlung mehrerer analoger Eingangssignale sind im FPGA also mehrere Eingangskomparatoren verwirklicht, während nur eine Samplingeinheit und nur eine Steuereinheit erforderlich sind, die ebenfalls wieder in FPGA verwirklicht sein können, und nur ein gemeinsamer Analogfilter erforderlich ist, der außerhalb des FPGA vorgesehen ist, was durch den Einsatz eines Multiplexers und Demultiplexers und eine entsprechende Anpassung der Steuereinheit ermöglicht wird. Damit kann auf eine Vervielfältigung der entsprechenden Bausteine wie insbesondere des Filternetzwerks für die einzelnen Kanäle verzichtet und zusätzlich eine Vielzahl von Eingängen des FPGA gespart werden, was deutlich geringere Kosten bzw. eine weitere Verfügbarkeit der vorhandenen restlichen Eingänge mit sich bringt.

Mit dem Einsatz eines ΣΔ-Modulators arbeitet der AD-Wandler auf der Basis des ΣΔ-Verfahrens, bei dem es sich um ein kontinuierliches, Mittelwert bildendes Verfahren handelt. Das System benötigt eine bestimmte Zeit, um sich auf einen neuen Wert einzustellen, wobei der ΣΔ-modulator stets dem Wert der Eingangsspannung folgt und einen pulsdichtemodulierten oder pulshäufigkeitsmodulierten Datenstrom erzeugt, der den Wert der Analogspannung in Form seines Mittelwertes darstellt. Ein Digitalwert kann schließlich durch digitale Mittelwertbildung (Tiefpassfilterung/Integration) aus dem pulshäufigkeitsmodulierten Datenstrom erzeugt werden. Der Vorteil beispielsweise gegenüber der Sukzessiven Approximation besteht darin, dass Störungen transienter Art unmittelbar durch die kontinuierliche Integration des pulshäufigkeitsmodulierten Datenstroms gemittelt werden und sich so im Ausgangssignal kaum oder gar nicht mehr bemerkbar machen. Die Ausmittelung steigt mit dem Grad der Überabtastung, die durch das Verhältnis zwischen der Frequenz, mit der das pulshäufigkeitsmodulierte Signal abgetastet wird, und der Nyquistfrequenz bestimmt ist, die sich aus der Signalbandbreite des Eingangssignals ergibt. Ein Abtast-Halte-Glied ist nicht erforderlich.

Die Erfindung wird im Folgenden anhand von Ausführungsbeispielen unter Bezugnahme auf die Zeichnung näher erläutert; in dieser zeigen:

Fig. 1 ein Blockschaltbild einer beispielhaften Ausführungs- form des erfindungsgemäßen mehrkanaligen AD- Wandlers,

Fig. 2 ein Blockschaltbild einer weiteren beispielhaften Aus- führungsform des erfindungsgemäßen mehrkanaligen Wandlers,

Fig. 3 eine beispielhafte Zählstruktur für das Auszählen des von einem jeweiligen Eingangskomparator kommenden Signals, und

Fig. 4 ein Zeitdiagramm einer beispielhaften, mit dem erfin- dungsgemäßen AD-Wandler durchführbaren Ana- log/ Digital-Wandlung.

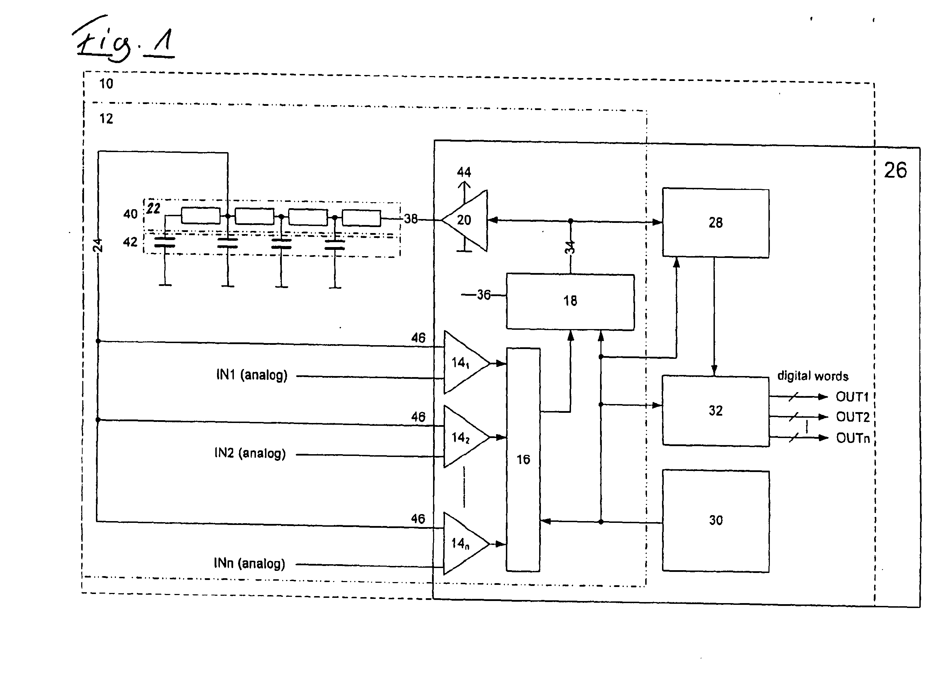

In Fig. 1 ist ein Blockschaltbild eines erfindungsgemäßen mehrkanaligen AD-Wandlers 10 zur Wandlung mehrerer analoger Eingangssignale $IN_1$ - $IN_n$ in ein jeweiliges digitales Ausgangssignal $OUT_1$ - $OUT_n$ gezeigt.

Der mehrkanalige AD-Wandler 10 weist einen $\Sigma\Delta$-Modulator 12 auf, der mehrere jeweils einem Eingangssignal $IN_1$ - $IN_n$ zugeordnete Eingangskomparatoren $14_1$ - $14_n$, eine diesen über einen Multiplexer 16 nachgeordnete Samplingeinheit 18 und eine einen DA-Wandler 20 sowie ein Filter 22 aufweisende Rückkoppelschleife 24 umfasst, über die das Ausgangssignal der Samplingeinheit 18 zu den Eingangskomparatoren $14_1$ - $14_n$ zurückgeführt ist. Dabei sind die Eingangskomparatoren $14_1$ - $14_n$, der Multiplexer 16, die Samplingeinheit 18 und der DA-Wandler 20 in einem FPGA 26 realisiert. Der Filter 22 ist als Analogfilter ausgeführt und außerhalb des FPGA 26 vorgesehen.

Der AD-Wandler 10 umfasst zudem eine Auswerteeinheit 28 zur Auswertung des Ausgangssignals der Samplingeinheit 18. Dabei ist bevorzugt auch diese Auswerteeinheit 28 wieder in dem FPGA 26 realisiert.

Die Auswerteeinheit 28 ist insbesondere zur Mittelung des Ausgangssignals der Samplingeinheit 18 über einen vorgebbaren Zeitraum ausgeführt. Dazu kann die Auswerteeinheit 28 verschiedene Filtertypen und beispielsweise wenigstens einen FIR-Filter und/oder wenigstens einen CIC-Filter umfassen. Die Auswerteeinheit 28 kann insbesondere auch so ausgeführt sein, dass die in einem jeweiligen vorgebbaren Zeitfenster auftretenden Abtastwerte "1" gezählt werden, wobei der sich am Ende des Zeitfensters ergebende Zählerstand dem Wandlungsergebnis entspricht.

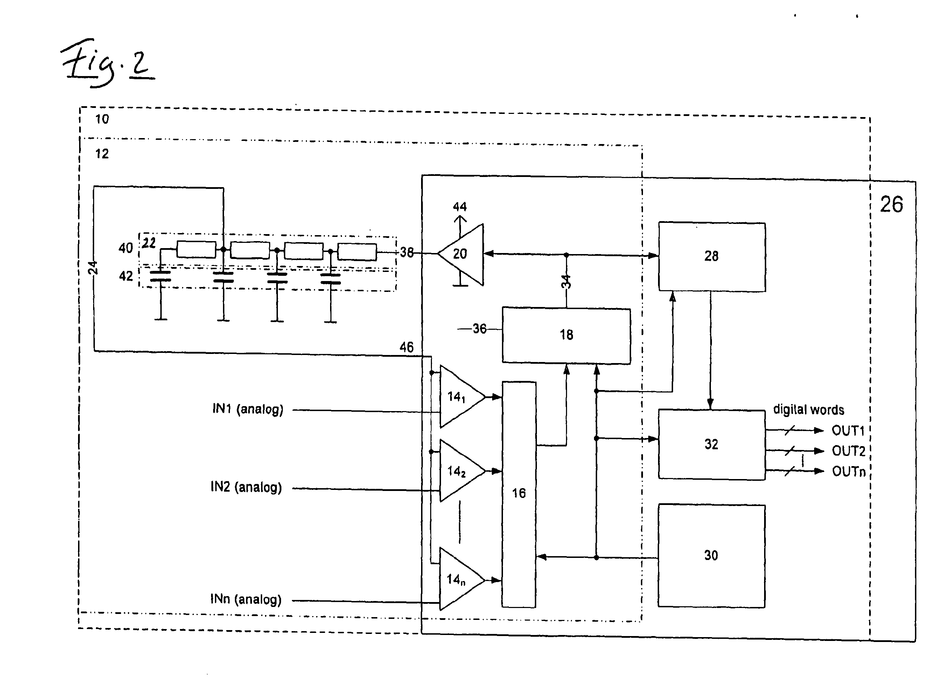

CIC-Filter bieten gegenüber FIR-Filtern einen geringeren Ressourcenverbrauch und eine kürzere Einschwingzeit. Am ressourcenschonendsten ist jedoch das hier bevorzugte Auszählen des von einem jeweiligen Komparator kommenden Signals in einer in der Figur 2 gezeigten und weiter unter näher erläuterten Zählstruktur, bei der in einem bestimmten Zeit- oder Messfenster jede auftretende "1" gezählt wird. Das Zählen kann synchron zum Start jedes Zeitfensters von einer Steuereinheit 30 gestartet und zum Ende hart abgebrochen werden. Nach Ablauf des Zeitfensters entspricht der Zählerstand dem Wandlungsergebnis. Die Steuereinheit 30 kann jetzt auf den nächsten Komparatoreingang umschalten und das nächste Zeitfenster starten, sobald der analoge Filter 22 sicher eingeschwungen ist. Eine möglichst schnelle, Timingfehler im Design vermeidende leistungsfähige Zählstruktur wird mit zwei in Reihe geschalteten Zählern erzielt.

Der AD-Wandler 10 umfasst zudem einen der Auswerteeinheit 28 nachgeordneten, die digitalen Ausgangssignale $OUT_1$ - $OUT_n$ liefernden Demultiplexer 32. Auch dieser Demultiplexer 32 ist bevorzugt wieder in den FPGA 26 realisiert.

Auch die zuvor erwähnte Steuereinheit 30 ist bevorzugt wieder in dem FPGA 26 realisiert. Diese insbesondere der Synchronisation sowie der Auswahl der jeweiligen Signalquelle dienende Steuereinheit 30 ist insbesondere zur Steuerung des Multiplexers 16, zur Steuerung der Samplingeinheit 18, zur Steuerung der Auswerteeinheit 28 und/oder zur Steuerung des Demultiplexers 32 vorgesehen.

Dabei kann die Steuereinheit 30 insbesondere so ausgeführt sein, dass die Ausgangssignale der Eingangskomparatoren $14_1$ - $14_n$ jeweils für ein vorgebbares Zeitfenster der Samplingeinheit 18 zugeführt werden, ein jeweiliger Start der Samplingeinheit 18 mit einem jeweiligen Start der Auswerteeinheit 28 synchronisiert wird und/oder der Demultiplexer zur Ausgabe der digitalen Ausgangssignale $OUT_1$ - $OUT_n$ entsprechend angesteuert wird.

Die Samplingeinheit 18 liefert einen pulshäufigkeitsmodulierten Datenstrom 34, der einerseits der Auswerteeinheit 28 und andererseits über den DA-Wandler 20 und den Analogfilter 22 zu Referenzeingängen 46 der Komparatoren $14_1$ - $14_n$ zurückgeführt wird, die das jeweilige analoge Eingangssignal $IN_1$ - $IN_n$ mit diesem rückgeführten Signal vergleichen. Der DA-Wandler 20 ist in der bevorzugten Ausführungsform ein einfacher Ausgangstreiber bzw. 1-Bit DA-Wandler, der nur über die beiden Zustände "LOW" und "HIGH" verfügt. In dem Analogfilter 22 wird das rückgeführte Signal im Wesentlichen integriert.

Die Samplingeinheit 18 arbeitet mit einer Abtastrate 36, die in an sich bekannter Weise um ein Vielfaches höher gewählt wird als durch das Abtasttheorem gefordert, sodass die Ausgangssignale der Eingangskomparatoren

$14_1$ - $14_n$ überabgetastet werden.

Der pulshäufigkeitsmodulierte Datenstrom 34 wird durch den DA-Wandler 20, der in der bevorzugten Ausführungsform eine Wortbreite von 1 Bit aufweist, in ein analoges Signal 38 umgewandelt und, wie bereits erwähnt, über den Analogfilter 22 an die Eingangskomparatoren $14_1$ - $14_n$ zurückgeführt.

Dem DA-Wandler 20 wird bei der dargestellten Ausführungsform ein Spannungs-Referenzwert $V_{Ref}$, beispielsweise dessen Versorgungsspannung 44, zur Verfügung gestellt, mit dem der Spannungspegel des DA-Wandler-Ausgangssignals 38 eingestellt wird.

Der außerhalb des FPGA 26 vorgesehene Analogfilter 22 kann insbesondere einen mehrpoligen Filter, vorzugsweise einen mehrpoligen RC-Filter umfassen. Bevorzugt umfasst dieser außerhalb des FPGA 26 vorgesehene Analogfilter 22 einen rekursiven vierpoligen RC-Filter, dessen Abgriff vorteilhafterweise nach dem dritten Pol vorgesehen ist. Dabei werden nur zwei analoge Netzwerke, nämlich das hier beispielsweise vier Widerstände umfassende Widerstandsnetzwerk 40 sowie das hier beispielsweise vier Kondensatoren umfassende Kondensatornetzwerk 42 benötigt. Dabei sind im Widerstandsnetzwerk 40 vorzugsweise identische Widerstände und im Kondensatornetzwerk 42 vorzugsweise identische Kondensatoren vorgesehen. Grundsätzlich kann jedoch auch ein anderer mehrpoliger Filter vorgesehen sein, vor allem ein dreipoliger Filter, wenn die größere Anzahl unterschiedlicher Bauteile und die entsprechend höheren Bestückungskosten in Kauf genommen werden, um die R- und C-Glieder individuell anzupassen. So wären für einen dreipoligen Filter insgesamt sechs unterschiedliche R- und C-Glieder einzusetzen.

Beim zuvor beschriebenen Ausführungsbeispiel wird davon ausgegangen, dass die Komparatoren im FPGA (Input-Buffer) einem differentiellen IO-Standard entsprechend konfiguriert sind, d.h. der invertierende und nicht invertierende Eingang eines Komparators jeweils mit einem FPGA-Pin verdrahtet wird. Der invertierende Eingang ist bei der gewählten Realisierung stets mit dem rekursiven Filterzweig verbunden, der nicht invertierende Eingang mit dem zu wandelnden Analogsignal. Für jedes Signal, das analog-digital gewandelt werden soll, werden folglich zwei Pins benötigt.

In Fig. 2 ist ein Blockschaltbild einer weiteren beispielhaften Ausführungsform des erfindungsgemäßen mehrkanaligen AD-Wandlers gezeigt. Verwendet man anstelle des differentiellen IO-Standards einen Single-Ended-IO-Standard und einen so genannten Referenzpin, dann kann man, wie insbesondere anhand dieser in der Figur 2 dargestellten Ausführungsform zu erkennen ist, die Anzahl der benötigten Pins reduzieren. Der Referenzpin ist mit dem invertierenden Eingang mehrerer Komparatoren verbunden, d.h. der rekursive Filterzweig muss nur noch mit dem entsprechenden Referenzpin verbunden werden. Dies ist störungstechnisch von Vorteil, da weniger Angriffspunkte für Störungen vorliegen.

Es kann bei dieser Ausführungsform gemäß Fig. 2 also der Referenzeingang des FPGA für die Eingangskomparatoren verwendet werden. Im Übrigen besitzt diese Ausführungsform zumindest im Wesentlichen wieder denselben Aufbau wie die gemäß Fig. 1, wobei einander entsprechenden Teilen gleiche Bezugszeichen zugeordnet sind.

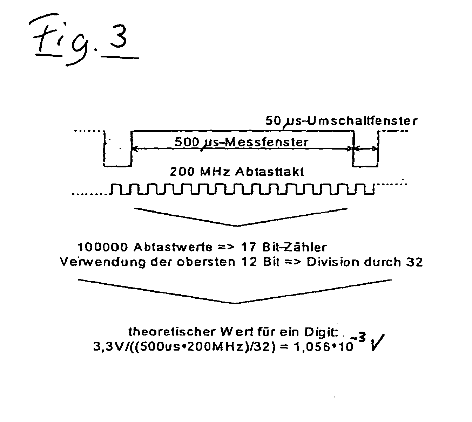

Fig. 3 zeigt eine beispielhafte Zählstruktur für das bevorzugte Auszählen des von einem jeweiligen Eingangskomparator $14_1$ - $14_n$ kommenden Signals. Dabei wird in einem bestimmten Zeit- oder Messfenster jede auftretende "1" gezählt. Das Zählen wird synchron zum Start jedes Messfensters von der Steuereinheit 30 gestartet und kann zum Ende hart abgebrochen werden. Nach Ablauf des Messfensters entspricht der Zählerstand dem Wandlungsergebnis. Die Steuereinheit 30 schaltet dann auf den nächsten Komparatoreingang um und startet das nächste Referenzfenster, sobald der analoge Filter 22 sicher eingeschwungen ist. Dabei hat beim vorliegenden Ausführungsbeispiel das Messfenster eine Länge von 500 μs. Ein jeweiliges Komparatorsignal wird beispielsweise mit einer Frequenz von 200 MHz abgetastet. Die Versorgungsspannung eines jeweiligen Komparators bzw. FPGAs beträgt beispielsweise 3,3 V. Der erste Zähler besitzt beispielsweise eine Breite von 3 Bit und summiert jede "1" innerhalb des Komparatorsignals auf. Der zweite Zähler hat beispielsweise eine Breite von 17 Bit und erhöht seinen Zählerstand um Vier, sobald das MSB (Most Significant Bit) des 3 Bit-Zählers seinen Wert ändert. Am Ende eines jeden Zeitfensters werden die obersten 12 Bit des 17 Bit-Zählers als Wandlungsergebnis abgespeichert, was einer Division durch 32 entspricht.

Die daraus resultierende Auflösung des Wandlers berechnet sich wie folgt:

$$3{,}3 \text{ V}/((500 \text{ μs} \cdot 200 \text{ MHz})/32) = 1{,}056 \cdot 10^{-3} \text{ V/Digit,}$$

was dem theoretischen Wert für ein Digit entspricht.

Eine Verkürzung der Systemauswertezeit kann insbesondere erreicht werden durch die Verwendung eines ressourcenschonenden CIC-Filters in der Auswerteeinheit und/oder ein "weiches" Abbrechen des Auszählens zum Ende des Messfensters.

Eine Verbesserung der Systemlinearität kann insbesondere erreicht werden durch eine Linearisierung des Wandlungsergebnisses nach der Zählerstruktur bzw. dem Digitalfilter.

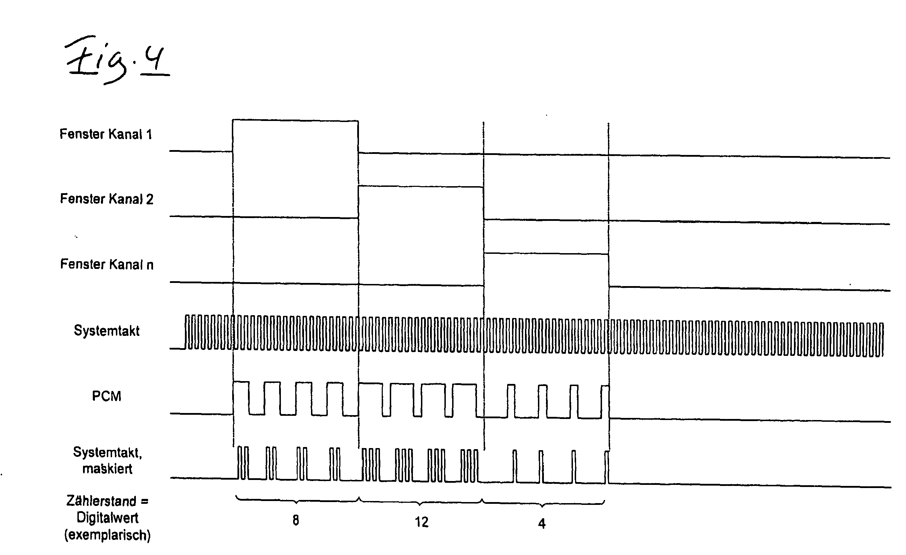

Fig. 4 zeigt ein Zeitdiagramm einer beispielhaften, mit dem erfindungsgemäßen AD-Wandler durchführbaren Analog/ Digital-Wandlung. Dabei ist rein beispielhaft ein Mehrkanalbetrieb für z.B. drei Kanäle bzw. analoge Eingangsgrößen dargestellt. Das pulshäufigkeitsmodulierte Signal (PCM) ist für folgende Eingangsspannungen wiedergegeben:

Kanal 1 = Versorgungsspannung/2 (V), Duty Cycle des PCM-Signals ist 50%
Kanal 2 = 0,75 . Versorgungsspannung (V), Duty Cycle des PCM-Signals ist 75%
Kanal n = Versorgungsspannung/3 (V), Duty Cycle des PCM-Signals ist 33%

In dieser Fig. 4 sind über der Zeit die den Kanälen 1 - n zugeordneten Fenster, der Systemtakt, das pulshäufigkeitsmodulierte Signal (PCM) und der durch das pulshäufigkeitsmodulierte Signal maskierte Systemtakt dargestellt. Während eines jeweiligen Fensters werden die Impulse des durch das pulshäufigkeitsmodulierte Signal (PCM) maskierten Systemtakts gezählt. Dabei ergibt sich im vorliegenden Fall für das dem Kanal 1 zugeordnete Fenster ein Zählerstand von 8, für das dem Kanal 2 zugeordnete Fenster ein Zählerstand von 12 und für das dem Kanal n zugeordnete Fenster ein Zählerstand von 4. Der jeweilige Zählerstand entspricht dann dem betreffenden Digitalwert.

Mit dem erfindungsgemäßen AD-Wandler werden eine Reihe von Vorteilen erzielt. So ergibt sich durch Nutzung moderner Elektronikkomponenten eine preisgünstig miniaturisierbare Lösung. Es ergeben sich gute Wandlungsergebnisse für einfache AD-Wandlungen (Auflösung zum Beispiel 12 Bit, integrale Nichtlinearität zum Beispiel < 1 %). Die Absolutgenauigkeit ist nur von Toleranzen der Referenz- bzw. Versorgungsspannung und nicht mehr von externen analogen Komponenten oder deren Temperaturgang abhängig. Mit dem $\Sigma\Delta$-Verfahren ergibt sich eine höhere Störsicherheit. Es ist bei minimalem Aufwand ein Mehrkanalbetrieb möglich. Es ist eine Wandlungszeit pro Kanal von insbesondere < 0,5 ms möglich. Der $\Sigma\Delta$-Modulator ist bis auf den Analogfilter vollständig in den FPGA integriert. Mit dem aus zwei Netzwerken aufgebauten Analogfilter ergibt sich eine Minimierung des Bauteilaufwands. Indem für mehrere Eingangssignale nur eine Samplingeinheit, nur eine Auswerteeinheit und nur eine Steuereinheit im FPGA verwirklicht werden muss, wird in diesem nur ein geringerer Logikanteil benötigt. Die Wandlungsergebnisse sind durch Erweiterung der Auswerteeinheit skalierbar.

**Bezugszeichenliste**

| | |
|---|---|
| 10 | AD-Wandler |
| 12 | $\Sigma\Delta$-Modulator |
| $14_1$ - $14_n$ | Eingangskomparatoren |
| 16 | Multiplexer |
| 18 | Samplingeinheit |
| 20 | DA-Wandler |
| 22 | Analogfilter |
| 24 | Rückkoppelschleife |
| 26 | FPGA |
| 28 | Auswerteeinheit |
| 30 | Steuereinheit |
| 32 | Demultiplexer |
| 34 | pulshäufigkeitsmodulierter Datenstrom |
| 36 | Abtastrate |
| 38 | Analoges Signal |
| 40 | Widerstandsnetzwerk |
| 42 | Kondensatornetzwerk |
| 44 | Versorgungsspannung |
| 46 | Referenzeingang |
| $IN_1$ - $IN_n$ | analoge Eingangssignale |
| $OUT_1$ - $OUT_n$ | digitale Ausgangssignale |

**Patentansprüche**

1.  Mehrkanaliger AD-Wandler (10) zur Wandlung mehrerer analoger Eingangssignale ($IN_1$ - $IN_n$) in ein jeweiliges digitales Ausgangssignal ($OUT_1$ - $OUT_n$), mit einem $\Sigma\Delta$-Modulator (12), der mehrere jeweils einem Eingangssignal ($IN_1$ - $IN_n$) zugeordnete Eingangskomparatoren ($14_1$ - $14_n$), eine diesen über einen Multiplexer (16) nachgeordnete Samplingeinheit (18) und eine einen DA-Wandler (20) sowie einen Filter (22) aufweisende Rückkoppelschleife (24) umfasst, über die das Ausgangssignal der Samplingeinheit (18) zu den Eingangskomparatoren ($14_1$ - $14_n$) zurück-

geführt ist, wobei die Eingangskomparatoren ($14_1$ - $14_n$), der Multiplexer (16), die Samplingeinheit (18) und der DA-Wandler (20) in einem FPGA (26) realisiert sind und der Filter (22) als Analogfilter ausgeführt und außerhalb des FPGA (26) vorgesehen ist.

**2.** Wandler nach Anspruch 1,
**dadurch gekennzeichnet,**
**dass** er eine Auswerteeinheit (28) zur Auswertung des Ausgangssignals der Samplingeinheit (18) umfasst.

**3.** Wandler nach Anspruch 2,
**dadurch gekennzeichnet,**
**dass** auch die Auswerteeinheit (28) in dem FPGA (26) realisiert ist.

**4.** Wandler nach Anspruch 2 oder 3,
**dadurch gekennzeichnet,**
**dass** die Auswerteeinheit (28) zur Mittelung des Ausgangssignals der Samplingeinheit (18) über einen vorgebaren Zeitraum ausgeführt ist.

**5.** Wandler nach einem der vorhergehenden Ansprüche,
**dadurch gekennzeichnet,**
**dass** die Auswerteeinheit (28) wenigstens einen FIR-Filter und/oder wenigstens einen CIC-Filter umfasst.

**6.** Wandler nach einem der vorhergehenden Ansprüche,
**dadurch gekennzeichnet,**
**dass** die Auswerteeinheit (28) so ausgeführt ist, dass die in einem jeweiligen vorgebbaren Zeitfenster auftretenden Abtastwerte "1" gezählt werden, wobei der sich am Ende des Zeitfensters ergebende Zählerstand dem Wandlungsergebnis entspricht.

**7.** Wandler nach einem der vorhergehenden Ansprüche,
**dadurch gekennzeichnet,**
**dass** er einen der Auswerteeinheit (28) nachgeordneten, die digitalen Ausgangssignale ($OUT_1$ - $OUT_n$) liefernden Demultiplexer (32) umfasst.

**8.** Wandler nach Anspruch 7,
**dadurch gekennzeichnet,**
**dass** auch der Demultiplexer (32) in dem FPGA (26) realisiert ist.

**9.** Wandler nach einem der vorhergehenden Ansprüche,
**dadurch gekennzeichnet,**
**dass** er eine Steuereinheit (30) umfasst.

**10.** Wandler nach Anspruch 9,
**dadurch gekennzeichnet,**
**dass** auch die Steuereinheit (30) in dem FPGA realisiert ist.

**11.** Wandler nach Anspruch 9 oder 10,
**dadurch gekennzeichnet,**
**dass** die Steuereinheit (30) zur Steuerung des Multiplexers (16), zur Steuerung der Samplingeinheit (18), zur Steuerung der Auswerteeinheit und/oder zur Steuerung des Demultiplexers (32) vorgesehen ist.

**12.** Wandler nach Anspruch 11,
**dadurch gekennzeichnet,**
**dass** die Steuereinheit (30) so ausgeführt ist, dass die Ausgangssignale der Eingangskomparatoren ($14_1$ - $14_n$) jeweils für ein vorgebbares Zeitfenster der Samplingeinheit (18) zugeführt werden, ein jeweiliger Start der Samplingeinheit (18) mit einem jeweiligen Start der Auswerteeinheit (28) synchronisiert wird und/oder der Demultiplexer (32) zur Ausgabe der digitalen Ausgangssignale ($OUT_1$ - $OUT_n$) entsprechend angesteuert wird.

**13.** Wandler nach einem der vorhergehenden Ansprüche,
**dadurch gekennzeichnet,**

**dass** der außerhalb des FPGA (26) vorgesehene Analogfilter (22) einen RC-Filter, insbesondere einen mehrpoligen RC-Filter umfasst.

14. Wandler nach Anspruch 13,
**dadurch gekennzeichnet,**
**dass** der außerhalb des FPGA (26) vorgesehene Analogfilter (22) einen rekursiven mehrpoligen RC-Filter umfasst.

15. Wandler nach Anspruch 13 oder 14,
**dadurch gekennzeichnet,**
**dass** der außerhalb des FPGA (26) vorgesehene Analogfilter (22) einen rekursiven vierpoligen RC-Filter umfasst, dessen Abgriff insbesondere nach dem dritten Pol vorgesehen ist.

**Claims**

1. A multichannel A/ D converter (10) for converting a plurality of analogue input signals ($IN_1$ - $IN_n$) into a respective digital output signal ($OUT_1$ - $OUT_n$) having an $\Sigma\Delta$ modulator (12) which includes a plurality of input comparators ($14_1$ - $14_n$) associated with an input signal ($IN_1$ - $IN_n$), a sampling unit (18) arranged downstream of said input comparators via a multiplexer (16) and a feedback loop (34) which has a D/A converter (20) as well as a filter (22) and via which the output signal of the sampling unit (18) is conducted back to the input comparators ($14_1$ - $14_n$), wherein the input comparators ($14_1$ - $14_n$), the multiplexer (16), the sampling unit (18) and the D / A converter (20) are realised in an FPGA (26) and the filter (22) is designed as an analogue filter and is provided outside the FPGA (26).

2. A converter in accordance with claim 1,
**characterised in that**
it includes an evaluation unit (28) for evaluating the output signal of the sampling unit (18).

3. A converter in accordance with claim 2,
**characterised in that**
the evaluation unit (28) is also realised in the FPGA (26).

4. A converter in accordance with claim 2 or claim 3,
**characterised in that**
the evaluation unit (28) is designed for averaging the output signal of the sampling unit (18) over a predefinable time period.

5. A converter in accordance with any one of the preceding claims,
**characterised in that**
the evaluation unit (28) includes at least one FIR filter and/or at least one CIC filter.

6. A converter in accordance with any one of the preceding claims,
**characterised in that**
the evaluation unit (28) is designed so that the sampling values "1" occurring in a respective predefinable time window are counted, with the count resulting at the end of the time window corresponding to the conversion result.

7. A converter in accordance with any one of the preceding claims,
**characterised in that**
it includes a demultiplexer (32) arranged downstream of the evaluation unit (28) and delivering the digital output signals ($OUT_1$ - $OUT_n$) .

8. A converter in accordance with claim 7,
**characterised in that**
the demultiplexer (32) is also realised in the FPGA (26).

9. A converter in accordance with any one of the preceding claims,
**characterised in that**
it includes a control unit (30).

**10.** A converter in accordance with claim 9,
**characterised in that**
the control unit (30) is also realised in the FPGA (26).

**11.** A converter in accordance with claim 9 or claim 10,
**characterised in that**
the control unit (30) is provided for controlling the multiplexer (16), for controlling the sampling unit (18), for controlling the evaluation unit and/or for controlling the demultiplexer (32).

**12.** A converter in accordance with claim 11,
**characterised in that**
the control unit (30) is designed so that the output signals of the input comparators ($14_1$ - $14_n$) are in each case supplied to the sampling unit (18) for a predefinable time window, a respective start of the sampling unit (18) is synchronised with a respective start of the evaluation unit (28) and/or the demultiplexer (32) is controlled accordingly for outputting the digital output signals ($OUT_1$ - $OUT_n$).

**13.** A converter in accordance with any one of the preceding claims,
**characterised in that**
the analogue filter (22) provided outside the FPGA (26) includes an RC filter, in particular a multipolar RC filter.

**14.** A converter in accordance with claim 13,
**characterised in that**
the analogue filter (22) provided outside the FPGA (26) includes a recursive multipolar RC filter.

**15.** A converter in accordance with claim 13 or claim 14,
**characterised in that**
the analogue filter (22) provided outside the FPGA (26) includes a recursive quadripolar RC filter whose pickup is in particular provided after the third pole.

**Revendications**

**1.** Convertisseur analogique-numérique multicanal (10) pour la conversion de plusieurs signaux d'entrée analogiques ($IN_1$-$IN_n$) en un signal de sortie numérique respectif ($OUT_1$-$OUT_n$) avec un modulateur $\Sigma\Delta$ (12) qui comprend plusieurs comparateurs d'entrée ($14_1$-$14_n$), une unité d'échantillonnage (18) agencée à la suite via un multiplexeur (16) et une boucle de rétroaction (24) comprenant un convertisseur numérique-analogique (20) ainsi qu'un filtre (22), via laquelle le signal de sortie de l'unité d'échantillonnage (18) est ramené au comparateur d'entrée ($14_1$-$14_n$), dans lequel les comparateurs d'entrée ($14_1$-$14_n$), le multiplexeur (16), l'unité d'échantillonnage (18) et le convertisseur numérique-analogique (20) sont réalisés dans un FPGA (26) et le filtre (22) est réalisé sous forme de filtre analogique et prévu à l'extérieur du FPGA (26).

**2.** Convertisseur selon la revendication 1,
**caractérisé en ce qu'**il comprend une unité d'évaluation (28) pour l'évaluation du signal de sortie de l'unité d'échantillonnage (18).

**3.** Convertisseur selon la revendication 2,
**caractérisé en ce que** l'unité d'évaluation (28) également est réalisée dans le FPGA (26).

**4.** Convertisseur selon la revendication 2 ou 3,
**caractérisé en ce que** l'unité d'évaluation (28) est réalisée pour effectuer une moyenne du signal de sortie de l'unité d'échantillonnage (18) sur une période temporelle prédéterminée.

**5.** Convertisseur selon l'une des revendications précédentes,
**caractérisé en ce que** l'unité d'évaluation (28) comprend au moins un filtre FIR et/ou au moins un filtre CIC.

**6.** Convertisseur selon l'une des revendications précédentes,
**caractérisé en ce que** l'unité d'évaluation (28) est réalisée de telle façon qu'elle compte les valeurs de palpage "1" qui se produisent dans une fenêtre temporelle respective prédéterminée, et l'état du compteur qui résulte à la fin de la fenêtre de comptage correspond au résultat de conversion.

7. Convertisseur selon l'une des revendications précédentes,
**caractérisé en ce qu'**il comprend un démultiplexeur (32) agencé à la suite de l'unité d'évaluation (28), qui fournit les signaux de sortie numériques ($OUT_1$-$OUT_n$).

8. Convertisseur selon la revendication 7,
**caractérisé en ce que** le démultiplexeur (32) également est réalisé dans le FPGA (26).

9. Convertisseur selon l'une des revendications précédentes,
**caractérisé en ce qu'**il comprend une unité de commande (30).

10. Convertisseur selon la revendication 9,
**caractérisé en ce que** l'unité de commande (30) également est réalisée dans le FPGA.

11. Convertisseur selon la revendication 9 ou 10,
**caractérisé en ce que** l'unité de commande (30) est prévue pour commander le multiplexeur (16), pour commander l'unité d'échantillonnage (18), pour commander l'unité d'évaluation et/ou pour commander le démultiplexeur (32).

12. Convertisseur selon la revendication 11,
**caractérisé en ce que** l'unité de commande (30) est réalisée de telle façon que les signaux de sortie des comparateurs d'entrée ($14_1$-$14_n$) sont alimentés, pour une fenêtre temporelle prédéterminée respective, à l'unité d'échantillonnage (18), un départ respectif de l'unité d'échantillonnage (18) est synchronisé avec un départ respectif de l'unité d'évaluation (28) et/ou le démultiplexeur (32) est piloté de façon correspondante pour délivrer les signaux de sortie numérique ($OUT_1$-$OUT_n$).

13. Convertisseur selon l'une des revendications précédentes,
**caractérisé en ce que** le filtre analogique (22) prévu à l'extérieur du FPGA (26) comprend un filtre RC, en particulier un filtre RC multipôle.

14. Convertisseur selon la revendication 13,
**caractérisé en ce que** le filtre analogique (22) prévu à l'extérieur du FPGA (26) comprend un filtre RC multipôle récursif.

15. Convertisseur selon la revendication 13 ou 14,
**caractérisé en ce que** le filtre analogique (22) prévu à l'extérieur du FPGA (26) comprend un filtre RC à quatre pôles récursif, dont la prise de sortie est prévue en particulier après le troisième pôle.

Fig. 1

Fig. 2

# Fig. 3

50 μs-Umschaltfenster

500 μs-Messfenster

200 MHz Abtasttakt

100000 Abtastwerte => 17 Bit-Zähler
Verwendung der obersten 12 Bit => Division durch 32

theoretischer Wert für ein Digit:
$3{,}3V/((500us \cdot 200MHz)/32) = 1{,}056 \cdot 10^{-3}$ V

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6246258 B1